# EUROPEAN PATENT SPECIFICATION

(11) **EP 4 138 119 B1**
(45) Date of publication and mention of the grant of the patent: **30.10.2024**
(21) Application number: 22190612.6
(22) Date of filing: 16.08.2022
(51) Int. Cl.: H01L 21/48, H01L 23/31, H01L 23/373, H01L 23/433, H01L 23/00, H01L 23/473, H01L 23/495, H01L 25/07

(54) **METHOD FOR PRODUCING POWER SEMICONDUCTOR MODULE AND POWER SEMICONDUCTOR MODULE**
VERFAHREN ZUR HERSTELLUNG EINES LEISTUNGSHALBLEITERMODULS UND LEISTUNGSHALBLEITERMODUL
PROCÉDÉ DE PRODUCTION DE MODULE SEMI-CONDUCTEUR DE PUISSANCE ET MODULE SEMI-CONDUCTEUR DE PUISSANCE

(30) Priority: 16.08.2021 CN 202110939295
(43) Date of publication of application: 22.02.2023
(73) Proprietor: Huawei Digital Power Technologies Co., Ltd., Shenzhen, Guangdong 518043 (CN)
(72) Inventor: DU, Ruoyang, Shenzhen, 518129 (CN); LV, Zhen, Shenzhen, 518129 (CN); GUO, Chaoyang, Shenzhen, 518129 (CN); WU, Wei, Shenzhen, 518129 (CN); WU, Bingzhi, Shenzhen, 518129 (CN)
(74) Representative: Gill Jennings & Every LLP

(56) References cited:
- EP-A1- 3 933 914
- EP-A2- 2 312 622
- WO-A1-2013/145471
- CN-A- 112 771 665
- DE-A1- 102012 204 159
- US-A1- 2011 037 166
- US-A1- 2020 321 224
- US-A1- 2021 013 175

## Description

### TECHNICAL FIELD

This application relates to the field of power semiconductors, and in particular, to a method for producing a power semiconductor module and a power semiconductor module.

### BACKGROUND

Currently, a power semiconductor module generally uses water cooling to ensure a temperature, but the power semiconductor module needs to have better sealing performance to use water cooling. At present, in some power semiconductor modules, a power device is first connected to a heat sink, and then the power device is packaged. It is difficult to ensure sealing performance of the power semiconductor module, and it is difficult to detect that the power device is properly sealed before use. In some other power semiconductor modules, a heat dissipation medium is filled between a power device and a heat sink, so that the power device is detachably connected to the heat sink. In this case, the power device may be first packaged in plastic. However, a relative position between the power device and the heat sink is not fixed. As a result, heat conduction efficiency of the heat dissipation medium is low, and a gap is likely to appear, thereby reducing heat dissipation efficiency by multiple times.

US 2020/321224 A1 provides a method for manufacturing a cooler for power devices.

### SUMMARY

This application provides a method for producing a power semiconductor module to seal the power semiconductor module and improve heat dissipation performance of the power semiconductor module.

A first aspect of embodiments of this application provides a method for producing a power semiconductor module in accordance with appended claim 1.

According to the method for producing a power semiconductor module, the power semiconductor module is produced through plastic packaging and then soldering, so that the power semiconductor module has better integrity. When the power device is packaged in plastic, position interference of the first heat sink can be avoided, so that the power semiconductor module has higher waterproof performance. When the first heat sink of the power semiconductor module takes away heat through liquid cooling, a coolant does not easily penetrate into the power semiconductor component of the power semiconductor module, and the power semiconductor component is protected, so that the power semiconductor component can stably work in a water cooling condition. In addition, sealing performance may be detected in advance, to improve reliability.

### BRIEF DESCRIPTION OF DRAWINGS

FIG. 1 is an exploded view of a power semiconductor module according to an embodiment of this application;
FIG. 2 is a sectional view of a power semiconductor module according to an embodiment of this application;
FIG. 3 is a flowchart of a method for producing a power semiconductor module according to an embodiment of this application;
FIG. 4 is an exploded view of a power semiconductor module according to another embodiment of this application;
FIG. 5 is a sectional view of a power semiconductor module according to another embodiment of this application; and
FIG. 6 is a flowchart of a method for producing a power semiconductor module according to another embodiment of this application.

**Description of main component symbols:**

| | |
|---|---|
| Power device | 110 |
| First member | 111 |
| Second member | 113 |
| Conductive gasket | 120 |
| First substrate | 130 |
| Second substrate | 140 |
| Conductor strip | 150 |
| Signal pin | 170 |
| Terminal | 190 |
| First material | 210 |
| Second material | 230 |
| Third material | 250 |
| Fourth material | 270 |
| Fifth material | 290 |
| First heat sink | 310 |
| Second heat sink | 330 |

In the following specific embodiments, this application is further described with reference to the accompanying drawings.

### DESCRIPTION OF EMBODIMENTS

The following describes implementations of this application by using specific embodiments. A person skilled in the art may easily learn of other advantages and effects of this application based on content disclosed in this specification. Although this application is described with reference to an example embodiment, it does not mean that a characteristic of this application is limited only to this implementation. On the contrary, a purpose of describing this application with reference to an implementation is to cover another option or modification that may be derived based on claims of this application. To provide an in-depth understanding of this application, the following descriptions include a plurality of specific details. This application may be alternatively implemented without using these details. In addition, to avoid confusion or blurring the focus of this application, some specific details will be omitted from the description. It should be noted that, when there is no conflict, embodiments in this application and the features in embodiments may be mutually combined.

The following terms "first", "second", and the like are merely used for description, and shall not be understood as an indication or implication of relative importance or implicit indication of a quantity of indicated technical features. Therefore, a feature limited by "first" or "second" may explicitly or implicitly include one or more of the features. In the descriptions of this application, unless otherwise stated, "a plurality of" means two or more than two. Orientation terms such as "up", "down", "left", and "right" are defined relative to an orientation of schematic placement of components in the accompanying drawings. It should be understood that these directional terms are relative concepts and are used for relative description and clarification. These directional terms may vary accordingly depending on an orientation in which the components are placed in the accompanying drawings.

In this application, unless otherwise explicitly specified and limited, a term "connection" should be understood in a broad sense. For example, the "connection" may be a fastened connection, a detachable connection, or an integrated connection; and may be a direct connection or an indirect connection by using an intermediate medium. The term "and/or" used in this specification includes any and all combinations of one or more related listed items.

When the following embodiments are described in detail with reference to schematic diagrams, for ease of description, a diagram indicating a partial structure of a component is partially enlarged not based on a general scale. In addition, the schematic diagrams are merely examples, and should not limit the protection scope of this application herein.

To make the objectives, technical solutions, and advantages of this application clearer, the following further describes implementations of this application in detail with reference to the accompanying drawings.

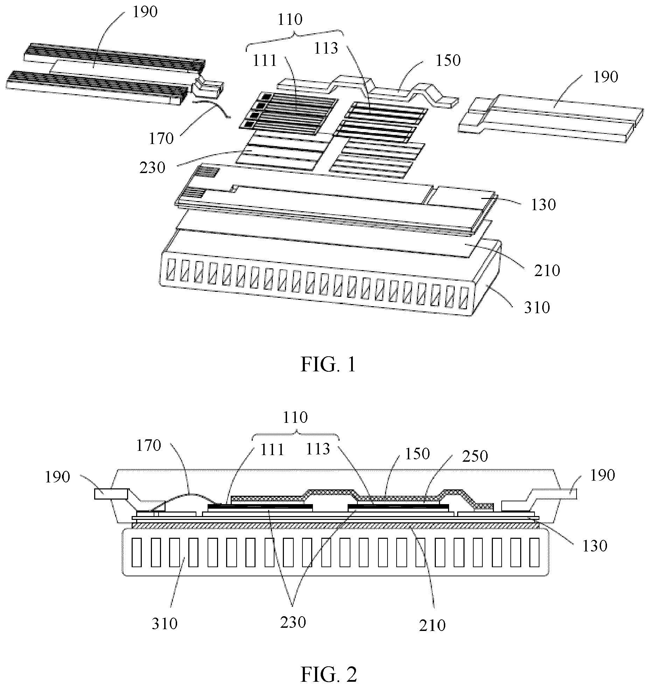

FIG. 1 is an exploded view of a power semiconductor module according to an embodiment of this application. FIG. 2 is a sectional view of a power semiconductor module according to an embodiment of this application.

As shown in FIG. 1, the power semiconductor module is a single-faced heat dissipation power semiconductor module that dissipates heat by using a first heat sink 310. The power semiconductor module includes a power semiconductor component and the first heat sink 310. A face that is of the power semiconductor component and that is close to the first heat sink 310 forms a first heat dissipation face (a reference numeral is added to a feature in the claims). The power semiconductor component and the first heat sink 310 are connected by using a first material 210. Heat generated by the power semiconductor component is transferred to the first heat sink 310 by using the first material 210, and then dissipated by using the first heat sink 310.

As shown in FIG. 2, the power semiconductor component includes a power device 110 and a first substrate 130. A face that is of the power device 110 and that faces the first heat sink 310 is connected to the first substrate 130 by using a second material 230. The first substrate 130 enables relative positions of parts of the power device 110 to be fixed. The first substrate 130 enables the power device 110 to have a larger heat dissipation area, thereby improving heat dissipation efficiency of the power device 110. Optionally, a direct bonding copper (Direct Bonding Copper, DBC) ceramic substrate is used as the first substrate 130. The DBC has a high thermal conductivity, and can quickly take the heat generated by the power device 110 away from the power device 110.

The power semiconductor component further includes a conductor strip 150. The power device 110 includes a first member 111 and a second member 113. The first member 111 and the second member 113 are connected to the conductor strip 150 by using a third material 250. The conductor strip 150 is disposed on a face that is of the power device 110 and that is away from the first substrate 130, to avoid position interference between the conductor strip 150 and the first substrate 130. The first member 111 and the second member 113 are electrically connected by using the conductor strip 150, so that the first member 111 and the second member 113 may be centrally powered, and a combination of the first member 111 and the second member 113 can work together to implement some functions. Optionally, the first member 111 may be an insulated gate bipolar transistor (Insulated Gate Bipolar Transistor), and the second member 113 may be a diode. The diode may protect the IGBT when a voltage or a current in the power device 110 suddenly changes.

The first member 111 is further electrically connected to a signal pin 170. The signal pin 170 is configured to connect to an external device to implement signal transfer with the power semiconductor component.

A first terminal 190 and a second terminal 190 are respectively connected to two ends of the power semiconductor component. Specifically, the first terminal 190 is connected to the first member 111, and the second terminal 190 is connected to the second member 113. The first terminal 190 and the second terminal 190 may implement on/off of the current by using a power semiconductor.

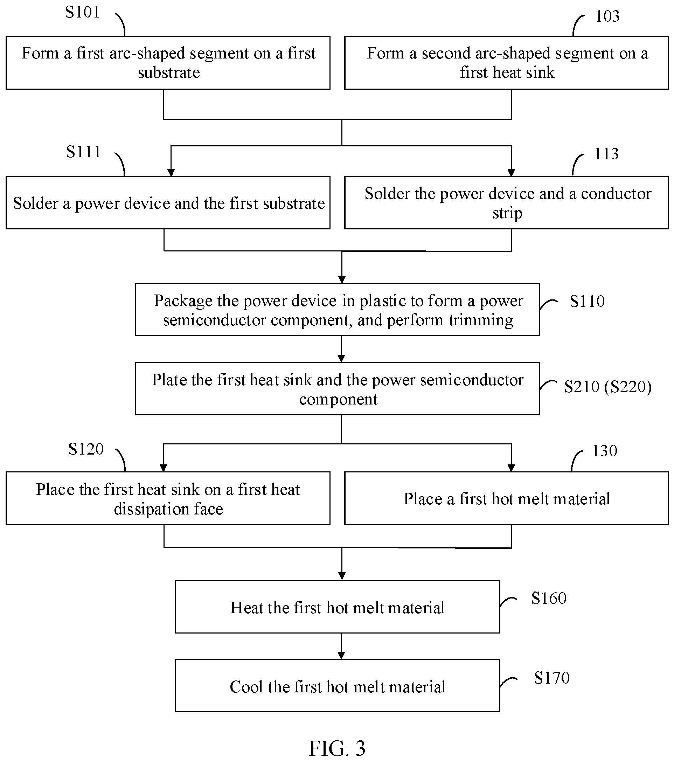

FIG. 3 is a flowchart of a method for producing a power semiconductor module according to an embodiment of this application. The method is used to produce the single-faced heat dissipation power semiconductor module.

As shown in FIG. 3, the method for producing a power semiconductor module includes the following steps.

S110: Package the power device 110 in plastic to form the power semiconductor component, and form a first heat dissipation face on a surface of the power semiconductor component. The plastically packaged power semiconductor component implements that the power semiconductor can have better waterproof performance. Heat of the power semiconductor component is taken away from the power semiconductor component by using the first heat dissipation face. After the power semiconductor component is formed through plastic packaging, the power semiconductor component is trimmed, and a surplus material that overflows during plastic packaging is removed.

S120: Place the first heat sink 310 on the first heat dissipation face. The first heat sink 310 is configured to receive heat of the first heat dissipation face, and dissipate the heat away from the power semiconductor component.

S130: Place the first material 210 between the first heat sink 310 and the first heat dissipation face. The first material 210 is placed between the first heat sink 310 and the first heat dissipation face and is configured to connect the first heat sink 310 and the power semiconductor component. In addition, the first material 210 may further have a heat transfer function, thereby improving heat transfer efficiency of the power semiconductor component and the first heat sink 310. Optionally, the first material 210 placed between the first heat sink 310 and the first heat dissipation face may be a solder pad or solder paste.

S 160: Heat the first material 210. The first material 210 is heated, so that the first material 210 is changed into a fluid state or is softened to generate a large intermolecular force, and the first material 210 can adhere to the power semiconductor component and the first heat sink 310.

S170: Cool the first material 210 on the first heat dissipation face to connect the power semiconductor component and the first heat sink 310. After the first material 210 is cooled, the first material 210 is changed from the fluid state back to a solid state or is hardened from a softened state, so that the first material 210 firmly connects the power semiconductor component and the first heat sink 310.

It may be understood that the S120 may be performed before the S130. For example, the first heat sink 310 and the power semiconductor component are first placed close to each other, so that there is a gap between the first heat dissipation face and the first heat sink 310, and then the gap is filled with the sheet-like first material 210. Alternatively, a sequence of the S120 and the S130 may be exchanged. The first material 210 is first placed on the first heat dissipation face or on the surface of the first heat sink 310, and then the first heat sink 310 is placed close to the first heat dissipation face, so that the first heat dissipation face and the first heat sink 310 clamp the first material 210.

Before the S120, the first heat sink 310 and/or the power semiconductor component may further be plated, which includes the following steps.

S210: Plate the first heat sink 310. A corrosion-resistant metal is plated on the surface of the first heat sink 310, so that corrosion resistance performance of the first heat sink 310 can be improved, and service life of the first heat sink 310 is prolonged. A plating layer may completely cover the first heat sink 310, or may cover only a face that is of the first heat sink 310 and that faces the power semiconductor component. An oxidized layer is removed after plating, so that heat dissipation efficiency of the first heat sink 310 can be maintained.

S220: Plate the power semiconductor component. A corrosion-resistant metal is plated on the surface of the power semiconductor component, so that corrosion resistance performance of the power semiconductor component may be improved, and service life of the power semiconductor component is prolonged.

The metal that is plated on the first heat sink 310 and/or the power semiconductor component may be a silver simple substance, a nickel simple substance, a tin simple substance, or a gold simple substance, or may be a composite metal formed by the foregoing metals.

In the step S130, the first material 210 needs to be sufficient. To make the first material 210 sufficient, an elevation member is disposed on a face that is of the first heat sink 310 and that is close to the power semiconductor component.

Optionally, when the elevation member is disposed on the first heat dissipation face, the elevation member includes a metal material that is disposed on the first heat dissipation face, and the metal material protrudes from the first heat dissipation face. Alternatively, the elevation member includes a bump that is disposed on the first heat dissipation face. Alternatively, the elevation member includes a groove that is disposed on the first heat dissipation face.

Optionally, when the elevation member is disposed on the first heat sink 310, the elevation member includes a metal material that is disposed on the surface of the first heat sink 310, and the metal material protrudes from the first heat dissipation face. Alternatively, the elevation member includes a bump that is disposed on the surface of the first heat sink 310. Alternatively, the elevation member includes a groove that is disposed on the surface of the first heat sink 310.

In the step S110, a connection between parts in the power semiconductor component is implemented by using the method for producing a power semiconductor component. The method for producing a power semiconductor component includes the following steps.

S111: Solder the first substrate 130 to a face of the power device 110 by using the second material 230, and form the first heat dissipation face on a face that is of the first substrate 130 and that is away from the power device 110. A melting point of the second material 230 is equal to or higher than a melting point of the first material 210. When the first material 210 is heated in step S104, the second material 230 may remain in a solid state, to maintain stability of the power semiconductor component.

S112: Solder, by using the third material 250, the conductor strip 150 to the face that is of the power device 110 and that is away from the first substrate 130. The power device 110 includes the first member 111 and the second member 113. The conductor strip 150 connects the first member 111 and the second member 113. A melting point of the third material 250 is equal to or higher than the melting point of the first material 210. When the first material 210 is heated in step S104, the third material 250 may remain in a solid state, to maintain stability of the power semiconductor component.

Before the step S110, the method further includes:
S101: Bend the first substrate 130 to form a first arc-shaped segment. The first arc-shaped segment is located in a middle part of the first substrate 130.

When the first substrate 130 and the power device 110 are soldered, the first arc-shaped segment can reduce warpage formed by soldering the first substrate 130, so that the first substrate 130 and the power device 110 are relatively flat after being soldered.

It may be understood that the first arc-shaped segment may not be formed in a bending manner. For example, when the first substrate 130 is formed, heat treatment may be performed to enable the first substrate 130 to have an internal stress for forming the first arc-shaped segment.

Before the step S120, the method further includes:
S103: Dispose a second arc-shaped segment on the first heat sink 310. The second arc-shaped segment is at a position that is of the first heat sink 310 and that corresponds to the power device 110.

When the step S130 and step S140 are completed, the second arc-shaped segment may reduce a warpage stress of the first heat sink 310, so that the first heat sink 310 and the power semiconductor component are relatively flat after being fastened.

When the single-faced heat dissipation power semiconductor module is produced, a relatively complete method for producing a power semiconductor module includes the following steps.

S101: Bend the first substrate 130 to form a first arc-shaped segment. The first arc-shaped segment is located in a middle part of the first substrate 130.

S103: Dispose a second arc-shaped segment on the first heat sink 310. The second arc-shaped segment is at a position that is of the first heat sink 310 and that corresponds to the power device 110.

S111: Solder the first substrate 130 to a face of the power device 110 by using the second material 230, and form the first heat dissipation face on a face that is of the first substrate 130 and that is away from the power device 110.

S112: Solder, by using the third material 250, the conductor strip 150 to the face that is of the power device 110 and that is away from the first substrate 130. The power device 110 includes the first member 111 and the second member 113. The conductor strip 150 connects the first member 111 and the second member 113.

S110: Package the power device 110 in plastic to form the power semiconductor component, and form the first heat dissipation face on the surface of the power semiconductor component. After the power semiconductor component is formed through plastic packaging, the power semiconductor component is trimmed, and a surplus material that overflows during plastic packaging is removed.

S210: Plate the first heat sink 310.

S220: Plate the power semiconductor component.

S120: Place the first heat sink 310 on the first heat dissipation face.

S130: Place the first material 210 between the first heat sink 310 and the first heat dissipation face.

S160: Heat the first material 210.

S170: Cool the first material 210 on the first heat dissipation face to connect the power semiconductor component and the first heat sink 310.

In the foregoing method for producing a power semiconductor module used to produce the single-faced heat dissipation power semiconductor module, the first material 210 may be heated by using different processes in the step S160.

Optionally, in the step S160, the first material 210 is heated through ultrasonic brazing. A method for heating the first material 210 through ultrasonic brazing includes:
S161a: Align the first material 210 by using an ultrasonic tool head.
S161b: Emit an ultrasonic wave to the first material 210 by using the ultrasonic tool head.

In the step S161a, a material of the ultrasonic tool head may be an aluminum alloy, a titanium alloy, or an alloy steel. All the aluminum alloy, the titanium alloy, and the alloy steel can apply an ultrasonic wave of sufficient amplitude to the power semiconductor or the first heat sink 310, so that a temperature of a soldered end face of the first material 210 reaches 220°C.

In the step S161a, the ultrasonic tool head may be a letter head, a two-claw tool head, or a four-claw tool head. For installation cases of different first materials 210 or different IGBTs, a plurality of tool heads may be used to simultaneously emit ultrasonic waves to the power semiconductor or the first heat sink 310.

In the step S161a, the ultrasonic tool head may generate an ultrasonic wave on the first heat dissipation face, a face that is of the first heat sink 310 and that is away from the power semiconductor component, a face that is of the first heat sink 310 and that faces the power semiconductor component, or a side face of the first heat sink 310. The ultrasonic wave can be kept away from the parts in the power semiconductor component, so that an internal temperature of the power semiconductor component is relatively low, to protect the power semiconductor.

When the first material 210 is heated through ultrasonic brazing, before the step S130, the method may further include the following steps:
S130a: Ultrasonically pre-coat the first material 210 on the first heat dissipation face.
S130b: Ultrasonically pre-coat the first material 210 on the face that is of the first heat sink 310 and that faces the power semiconductor component.

The first material 210 is ultrasonically pre-coated on the first heat dissipation face and/or the first heat sink 310, so that strength of a connection between the power semiconductor component and the first heat sink 310 can be improved, and heat transfer efficiency between the power semiconductor component and the first heat sink 310 can also be improved.

In the step S160, when the first material 210 is heated through ultrasonic brazing, a first material combination may be used. In the first material combination, the first material 210 may be a multi-element alloy solder paste, the second material 230 may be sintered silver, and the third material 250 may be SAC305. In SAC305, a weight percentage of tin is 96.5%, a weight percentage of silver is 3.0%, and a weight percentage of copper is 0.5%. The multi-element alloy solder paste is a solder paste that is formed by adding a supporting metal material to a Sn-Ag-Cu series solder paste.

In the step S160, the first material combination is used. When the first material 210 is heated through ultrasonic brazing, a temperature is controlled between 150°C and 180°C. In this case, the ultrasonic brazing concentrates heat at the first material 210, so that the first material 210 formed by the multi-element alloy solder paste is heated and melted. The second material 230 formed by the sintered silver and the third material 250 formed by SAC305 remain in a solid state, to maintain stability of the power semiconductor component. A melting point of the sintered silver and a melting point of SAC305 are higher than that of the multi-element alloy solder paste. When a temperature is controlled between 150°C and 180°C, the sintered silver and SAC305 in the power semiconductor component are not melted.

In the step S160, when the first material 210 is heated through ultrasonic brazing, a second material combination may also be used. In the second material combination, the first material 210 may be SnSb5, the second material 230 may be sintered silver, and the third material 250 may be SnSb5. In SnSb5, a weight percentage of tin is 95% and a weight percentage of antimony is 5%.

In the step S160, the second material combination is used. When the first material 210 is heated through ultrasonic brazing, a temperature is controlled between 210°C and 220°C. In this case, the ultrasonic brazing concentrates heat at the first material 210, so that the first material 210 formed by SnSb5 is heated and melted. The second material 230 formed by the sintered silver and the third material 250 formed by SnSb5 remain in a solid state, to maintain stability of the power semiconductor component. A melting point of the sintered silver is higher than that of SnSb5. When a temperature is controlled between 210°C and 220°C, the sintered silver in the power semiconductor component is not melted. The ultrasonic brazing concentrates the heat at the first material 210, and a temperature of the second material 230 in the power semiconductor component is lower than a temperature of the first material 210, so that when the temperature of the first material 210 is controlled between 210°C and 220°C, the temperature of the second material 230 that connects the power device 110 and the conductor strip 150 has not reached the melting point of SnSb5, and the second material 230 is not melted.

In the step S160, when the first material 210 is heated through ultrasonic brazing, a third material combination may also be used. In the third material combination, the first material 210 may be a multi-element alloy solder paste or SAC305, the second material 230 may be sintered silver, and the third material 250 may be SnSb5.

In the step S160, the third material combination is used. When the first material 210 is heated through ultrasonic brazing, a temperature is controlled between 210°C and 220°C. In this case, the ultrasonic brazing concentrates heat at the first material 210, so that the first material 210 formed by the multi-element alloy solder paste or SAC305 is heated and melted. The second material 230 formed by the sintered silver and the third material 250 formed by SnSb5 remain in a solid state, to maintain stability of the power semiconductor component. A melting point of the sintered silver is higher than that of SnSb5. When a temperature is controlled between 210°C and 220°C, the sintered silver in the power semiconductor component is not melted. The ultrasonic brazing concentrates the heat at the first material 210, and a temperature of the second material 230 in the power semiconductor component is lower than a temperature of the first material 210, so that when the temperature of the first material 210 is controlled between 210°C and 220°C, the temperature of the second material 230 that connects the power device 110 and the conductor strip 150 has not reached the melting point of SnSb5, and the second material 230 is not melted.

Optionally, in the step S160, the first material 210 is heated through vacuum reflow soldering. The vacuum reflow soldering can also concentrate heat in an area in which the first material 210 is located, so that a temperature gradient is formed between the power semiconductor and the heat sink, and an internal temperature of the power semiconductor is reduced when the first material 210 is melted. Vacuum may reduce a bubble inside the first material 210 after the first material 210 is melted, so that after the first material 210 is cooled, strength of a connection between the power semiconductor component and the first heat sink 310 that are connected through soldering is higher.

In the step S160, when the first material 210 is heated through vacuum reflow soldering, a fourth material combination may be used. In the fourth material combination, the first material 210 may be a multi-element alloy solder paste or SAC305, the second material 230 may be sintered silver, and the third material 250 may be SnSb5.

In the step S160, the fourth material combination is used. When the first material 210 is heated through vacuum reflow soldering, a temperature is controlled between 210°C and 220°C. In this case, the vacuum reflow soldering concentrates heat at the first material 210, so that the first material 210 formed by the multi-element alloy solder paste or SAC305 is heated and melted. The second material 230 formed by the sintered silver and the third material 250 formed by SnSb5 remain in a solid state, to maintain stability of the power semiconductor component. A melting point of the sintered silver is higher than that of SnSb5. When a temperature is controlled between 210°C and 220°C, the sintered silver in the power semiconductor component is not melted. A temperature of the second material 230 in the power semiconductor component is lower than a temperature of the first material 210, so that when the temperature of the first material 210 is controlled between 210°C and 220°C, the temperature of the second material 230 that connects the power device 110 and the conductor strip 150 has not reached the melting point of SnSb5, and the second material 230 is not melted.

In the step S160, when the first material 210 is heated through vacuum reflow soldering, a fifth material combination may be used. In the fifth material combination, the first material 210 may be any one of SnSb5, a multi-element alloy solder paste, and SAC305, the second material 230 may be sintered silver, and the third material 250 may be a high-lead solder paste.

In the step S160, the fifth material combination is used. When the first material 210 is heated through vacuum reflow soldering, a temperature is controlled between 240°C and 260°C. In this case, the vacuum reflow soldering concentrates heat at the first material 210, so that any one of SnSb5, the multi-element alloy solder paste, and SAC305 may be heated and melted at this temperature. The second material 230 formed by the sintered silver and the third material 250 formed by the high-lead solder paste remain in a solid state, to maintain stability of the power semiconductor component.

Optionally, in the step S160, the first material 210 is heated through sintering. During sintering, the first material 210 experiences a small external force, and is in a relatively static state. A diffusion region of the first material 210 after being melted is easy to control.

In the step S160, when the first material 210 is heated through sintering, a sixth material combination may be used. In the sixth material combination, the first material 210 may be nano silver, the second material 230 may be sintered silver, and the third material 250 may be a high-lead solder paste.

In the step S160, the sixth material combination is used. When the first material 210 is heated through sintering, a temperature is controlled between 270 and 290°C, the nano silver may be softened at this temperature to form a relatively large intermolecular force. The second material 230 formed by the sintered silver and the third material 250 formed by the high-lead solder paste remain in a solid state, to maintain stability of the power semiconductor component.

It may be understood that when the first material 210 is heated through sintering, the first material 210 may also be micron silver or copper particles. When the first material 210 is heated and softened, the second material 230 and the third material 250 remain in a solid state.

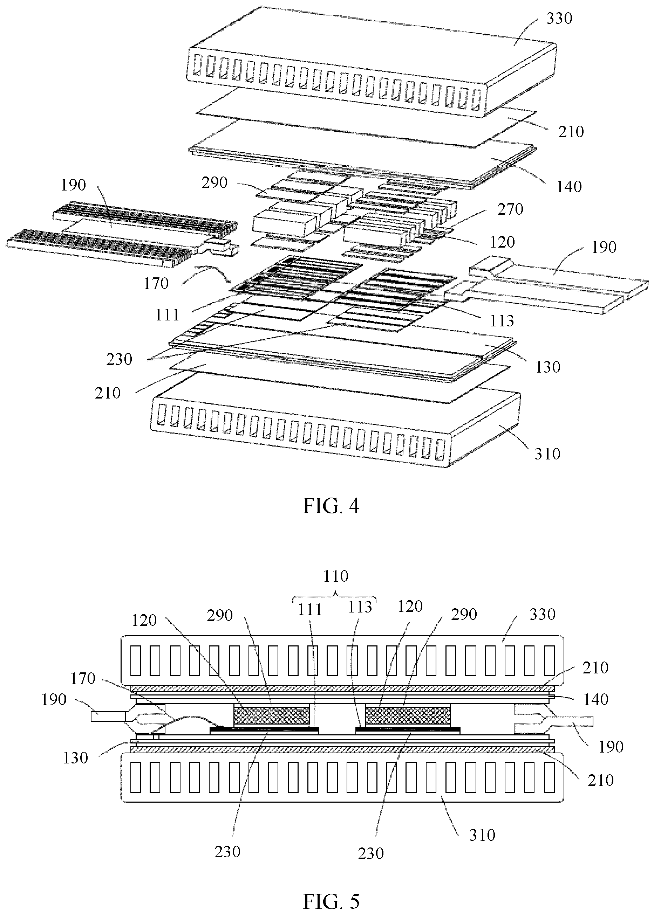

FIG. 4 is an exploded view of a power semiconductor module according to another embodiment of this application. FIG. 5 is a sectional view of a power semiconductor module according to another embodiment of this application.

As shown in FIG. 5, the power semiconductor module is a double-faced heat dissipation power semiconductor module that dissipates heat by using a first heat sink 310 and a second heat sink 330. The power semiconductor module includes a power semiconductor component, the first heat sink 310, and the second heat sink 330. A face that is of the power semiconductor component and that is close to the first heat sink 310 forms a first heat dissipation face. The power semiconductor component and the first heat sink 310 are connected by using a first material 210. A face that is of the power semiconductor component and that is close to the second heat sink 330 forms a second heat dissipation face. The power semiconductor component and the second heat sink 330 are connected by using a first material 210. In other words, the first heat dissipation face and the second heat dissipation face are made of a same material, so that both the first heat sink 310 and the second heat sink 330 may be connected to a power semiconductor. Heat generated by the thermal power semiconductor component is transferred to the first heat sink 310 by using the first material 210 on the first heat dissipation face, and then is dissipated by using the first heat sink 310. In addition, heat generated by the thermal power semiconductor component is further transferred to the second heat sink 330 by using the first material 210 on the second heat dissipation face, and then is dissipated by using the second heat sink 330.

As shown in FIG. 4, the power semiconductor component includes a power device 110, a first substrate 130, a second substrate 140, and a conductive pad 120. A face that is of the power device 110 and that faces the first heat sink 310 is connected to the first substrate 130 by using a second material 230. The first substrate 130 enables relative positions of parts of the power device 110 to be fixed. The first substrate 130 enables the power device 110 to have a larger heat dissipation area, thereby improving heat dissipation efficiency of the power device 110. Optionally, DBC is used as the first substrate 130. The DBC has a high thermal conductivity, and can quickly take the heat generated by the power device 110 away from the power device 110.

The power device 110 includes a first member 111 and a second member 113. The first member 111 and the second member 113 are connected to a conductive pad 120 by using a third material 250. The conductive pad 120 is disposed on a face that is of the power device 110 and that is away from the first substrate 130. The first member 111 and the second member 113 are electrically connected by using the conductive pad 120, so that the first member 111 and the second member 113 may be centrally powered, and a combination of the first member 111 and the second member 113 can work together to implement some functions. Optionally, the first member 111 may be an IGBT, and the second member 113 may be a diode. The diode may protect the IGBT when a voltage or a current in the power device 110 suddenly changes.

The first member 111 is further electrically connected to a signal pin 170. The signal pin 170 is configured to connect to an external device to implement signal transfer with the power semiconductor component.

The second substrate 140 is soldered to a face that is of the conductive pad 120 and that is away from the power device 110 by using a fifth material 290. The second substrate 140 can receive heat emitted from the conductive pad 120, so that the power device 110 has a larger heat dissipation area, thereby improving heat dissipation efficiency of the power device 110. Optionally, DBC is used as the second substrate 140. The DBC has a high thermal conductivity, and can quickly take the heat generated by the power device 110 away from the power device 110.

A first terminal 190 and a second terminal 190 are respectively connected to two ends of the power semiconductor component. Specifically, the first terminal 190 is connected to the first member 111, and the second terminal 190 is connected to the second member 113. The first terminal 190 and the second terminal 190 may implement on/off of the current by using the power semiconductor.

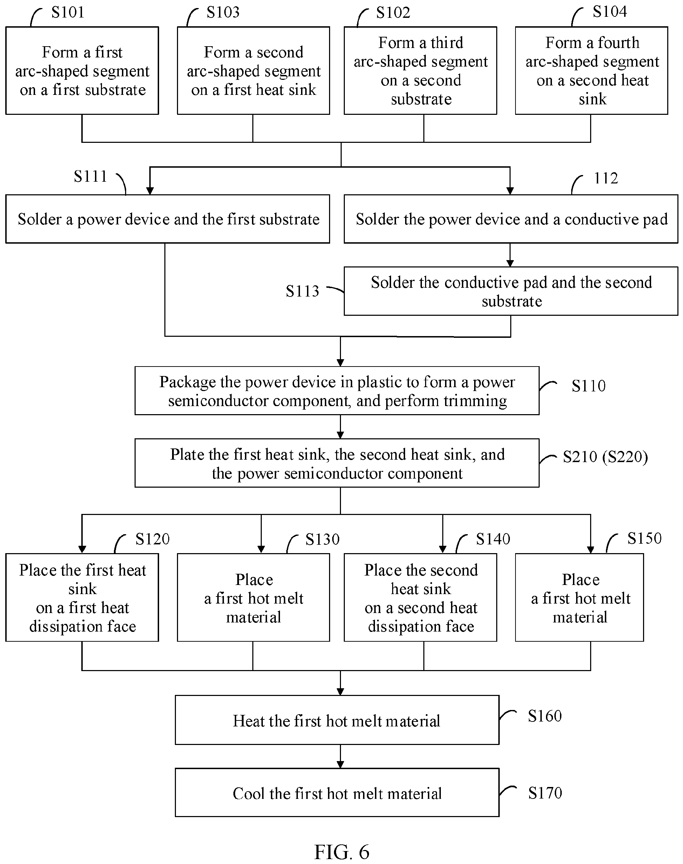

FIG. 6 is a flowchart of a method for producing a power semiconductor module according to another embodiment of this application. The method is used to produce the double-faced heat dissipation power semiconductor module.

As shown in FIG. 6, the method for producing a power semiconductor module includes the following steps.

S110: Package the power device 110 in plastic to form the power semiconductor component, and form a first heat dissipation face on a surface of the power semiconductor component. The plastically packaged power semiconductor component implements that the power semiconductor can have better waterproof performance. Heat of the power semiconductor component is taken away from the power semiconductor component by using the first heat dissipation face. After the power semiconductor component is formed through plastic packaging, the power semiconductor component is trimmed, and a surplus material that overflows during plastic packaging is removed.

S120: Place the first heat sink 310 on the first heat dissipation face. The first heat sink 310 is configured to receive heat of the first heat dissipation face, and dissipate the heat away from the power semiconductor component.

S130: Place the first material 210 between the first heat sink 310 and the first heat dissipation face. The first material 210 is disposed between the first heat sink 310 and the first heat dissipation face and is configured to connect the first heat sink 310 and the power semiconductor component. In addition, the first material 210 may further have a heat transfer function, thereby improving heat transfer efficiency of the power semiconductor component and the first heat sink 310. Optionally, the first material 210 disposed between the first heat sink 310 and the first heat dissipation face may be a solder pad or solder paste.

S140: Dispose the second heat sink 330 on the second heat dissipation face. The second heat sink 330 is configured to receive heat of the second heat dissipation face, and dissipate the heat away from the power semiconductor component.

S150: Place the first material 210 between the second heat sink 330 and the second heat dissipation face. The first material 210 is disposed between the second heat sink 330 and the second heat dissipation face and is configured to connect the second heat sink 330 and the power semiconductor component. In addition, the first material 210 may further have a heat transfer function, thereby improving heat transfer efficiency of the power semiconductor component and the second heat sink 330. Optionally, the first material 210 disposed between the second heat sink 330 and the second heat dissipation face may be a solder pad or solder paste.

S 160: Heat the first material 210. The first material 210 is heated, so that the first material 210 is changed into a fluid state, so that a gap between the first heat sink 310 and the first heat dissipation face is filled with the first material 210 on the first heat dissipation face, and a gap between the second heat sink 330 and the second heat dissipation face is filled with the first material 210 on the second heat dissipation face.

S170: Cool the first materials 210 on the first heat dissipation face and the second heat dissipation face to connect the power semiconductor component, the first heat sink 310, and the second heat sink 330. After the first material 210 is cooled, the power semiconductor component and the first heat sink 310 are fastened by using the first material 210 on the first heat dissipation face, and the power semiconductor component and the second heat sink 330 are fastened by using the first material 210 on the second heat dissipation face.

It may be understood that the S120 may be performed before the S130. For example, the first heat sink 310 and the power semiconductor component are first placed close to each other, so that there is a gap between the first heat dissipation face and the first heat sink 310, and then the gap is filled with the sheet-like first material 210. Alternatively, a sequence of the S120 and the S130 may be exchanged. The first material 210 is first placed on the first heat dissipation face or on the surface of the first heat sink 310, and then the first heat sink 310 is placed close to the first heat dissipation face, so that the first heat dissipation face and the first heat sink 310 clamp the first material 210.

It may be understood that the S140 may be performed before the S150. For example, the second heat sink 330 and the power semiconductor component are first placed close to each other, so that there is a gap between the second heat dissipation face and the second heat sink 330, and then the gap is filled with the sheet-like first material 210. Alternatively, a sequence of the S140 and the S150 may be exchanged. The first material 210 is first placed on the second heat dissipation face or on a surface of the second heat sink 330, and then the second heat sink 330 is placed close to the second heat dissipation face, so that the second heat dissipation face and the second heat sink 330 clamp the first material 210.

Before the S120, the heat sink and/or the power semiconductor component may further be plated, which includes the following steps.

S210: Plate the first heat sink 310 and the second heat sink 330. Corrosion-resistant metals are plated on the surface of the first heat sink 310 and the surface of the second heat sink 330, so that corrosion resistance performance of the first heat sink 310 and the second heat sink 330 can be improved, and service life of the first heat sink 310 and the second heat sink 330 is prolonged. A plating layer may completely cover each of the first heat sink 310 and the second heat sink 330, or may cover only a face that is of the first heat sink 310 or the second heat sink 330 and that faces the power semiconductor component. An oxidized layer is removed after plating, so that heat dissipation efficiency of the first heat sink 310 and the second heat sink 330 can be maintained.

S220: Plate the power semiconductor component. A corrosion-resistant metal is plated on the surface of the power semiconductor component, so that corrosion resistance performance of the power semiconductor component may be improved, and service life of the power semiconductor component is prolonged.

The metal that is plated on the first heat sink 310 and/or the power semiconductor component may be a silver simple substance, a nickel simple substance, a tin simple substance, or a gold simple substance, or may be a composite metal formed by the foregoing metals.

It may be understood that only one or both of the first heat sink 310, the second heat sink 330, and the power semiconductor may be plated, to improve corrosion resistance of a plated part.

In the step S130, the first material 210 needs to be sufficient. To make the first material 210 sufficient, an elevation member is disposed on a face that is of the first heat sink 310 and that is close to the power semiconductor component.

Optionally, when the elevation member is disposed on the first heat dissipation face, the elevation member includes a metal material that is disposed on the first heat dissipation face, and the metal material protrudes from the first heat dissipation face. Alternatively, the elevation member includes a bump that is disposed on the first heat dissipation face. Alternatively, the elevation member includes a groove that is disposed on the first heat dissipation face.

Optionally, when the elevation member is disposed on the first heat sink 310, the elevation member includes a metal material that is disposed on the surface of the first heat sink 310, and the metal material protrudes from the first heat dissipation face. Alternatively, the elevation member includes a bump that is disposed on the surface of the first heat sink 310. Alternatively, the elevation member includes a groove that is disposed on the surface of the first heat sink 310.

In the step S150, the first material 210 needs to be sufficient. To make the first material 210 sufficient, an elevation member is disposed on a face that is of the second heat sink 330 and that is close to the power semiconductor component.

Optionally, when the elevation member is disposed on the second heat dissipation face, the elevation member includes a metal material that is disposed on the second heat dissipation face, and the metal material protrudes from the second heat dissipation face. Alternatively, the elevation member includes a bump that is disposed on the second heat dissipation face. Alternatively, the elevation member includes a groove that is disposed on the second heat dissipation face.

Optionally, when the elevation member is disposed on the second heat sink 330, the elevation member includes a metal material that is disposed on the surface of the second heat sink 330, and the metal material protrudes from the second heat dissipation face. Alternatively, the elevation member includes a bump that is disposed on the surface of the second heat sink 330. Alternatively, the elevation member includes a groove that is disposed on the surface of the second heat sink 330.

In the step S110, a connection between parts in the power semiconductor component is implemented by using the method for producing a power semiconductor component. The method for producing a power semiconductor component includes the following steps.

S111: Solder the first substrate 130 to a face of the power device 110 by using the second material 230, and form the first heat dissipation face on a face that is of the first substrate 130 and that is away from the power device 110. A melting point of the second material 230 is equal to or higher than a melting point of the first material 210. When the first material 210 is heated in step S104, the second material 230 may remain in a solid state, to maintain stability of the power semiconductor component.

S 112: Solder, by using a fourth material 270, the conductive pad 120 to a face that is of the power device 110 and that is away from the first substrate 130. The power device 110 includes the first member 111 and the second member 113. The conductive pad 120 connects the first member 111 and the second member 113. A melting point of the fourth material 270 is equal to or higher than the melting point of the first material 210. When the first material 210 is heated in step S104, the fourth material 270 may remain in a solid state, to maintain stability of the power semiconductor component.

S113: Solder the second substrate 140 to a face that is of the conductive pad 120 and that is away from the power device 110 by using a fifth material 290. A melting point of the fifth material 290 is equal to or higher than the melting point of the first material 210. When the first material 210 is heated in step S104, the fifth material 290 may remain in a solid state, to maintain stability of the power semiconductor component.

Before the step S110, the method further includes:
S101: Bend the first substrate 130 to form a first arc-shaped segment. The first arc-shaped segment is located in a middle part of the first substrate 130.

When the first substrate 130 and the power device 110 are soldered, the first arc-shaped segment can reduce warpage formed by soldering the first substrate 130, so that the first substrate 130 and the power device 110 are relatively flat after being soldered.

S102: Bend the second substrate 140 to form a third arc-shaped segment. The third arc-shaped segment is located in a middle part of the second substrate 140.

When the second substrate 140 and the conductive pad 120 are soldered, the third arc-shaped segment can reduce warpage formed by soldering the second substrate 140, so that the second substrate 140 and the conductive pad 120 are relatively flat after being soldered.

It may be understood that the first arc-shaped segment and the third arc-shaped segment may not be formed in a bending manner. For example, when the first substrate 130 or the second substrate 140 is formed, heat treatment may be performed to enable the first substrate 130 or the second substrate 140 to have an internal stress for forming the arc-shaped segment.

Before the step S120, the method further includes:
S103: Dispose a second arc-shaped segment on the first heat sink 310. The second arc-shaped segment is at a position that is of the first heat sink 310 and that corresponds to the power device 110.

When the step S130 and the step S140 are completed, the second arc-shaped segment may reduce a warpage stress of the first heat sink 310, so that the first heat sink 310 and the power semiconductor component are relatively flat after being fastened.

S104: Dispose a fourth arc-shaped segment on the second heat sink 330. The fourth arc-shaped segment is at a position that is of the second heat sink 330 and that corresponds to the power device 110.

When the step S130 and the step S140 are completed, the fourth arc-shaped segment may reduce a warpage stress of the second heat sink 330, so that the second heat sink 330 and the power semiconductor component are relatively flat after being fastened.

When the double-faced heat dissipation power semiconductor module is produced, a relatively complete method for producing a power semiconductor module includes the following steps.

S101: Bend the first substrate 130 to form a first arc-shaped segment. The first arc-shaped segment is located in a middle part of the first substrate 130.

S102: Bend the second substrate 140 to form a third arc-shaped segment. The third arc-shaped segment is located in a middle part of the second substrate 140.

S103: Dispose a second arc-shaped segment on the first heat sink 310. The second arc-shaped segment is at a position that is of the first heat sink 310 and that corresponds to the power device 110.

S104: Dispose a fourth arc-shaped segment on the second heat sink 330. The fourth arc-shaped segment is at a position that is of the second heat sink 330 and that corresponds to the power device 110.

S111: Solder the first substrate 130 to a face of the power device 110 by using the second material 230, and form the first heat dissipation face on a face that is of the first substrate 130 and that is away from the power device 110.

S112: Solder, by using a fourth material 270, the conductive pad 120 to a face that is of the power device 110 and that is away from the first substrate 130. The power device 110 includes the first member 111 and the second member 113. The conductive pad 120 connects the first member 111 and the second member 113.

S113: Solder the second substrate 140 to a face that is of the conductive pad 120 and that is away from the power device 110 by using a fifth material 290.

S110: Package the power device 110 in plastic to form the power semiconductor component, and form the first heat dissipation face on the surface of the power semiconductor component. After the power semiconductor component is formed through plastic packaging, the power semiconductor component is trimmed, and a surplus material that overflows during plastic packaging is removed.

S210: Plate the first heat sink 310 and the second heat sink 330.

S220: Plate the power semiconductor component.

S120: Place the first heat sink 310 on the first heat dissipation face.

S130: Place the first material 210 between the first heat sink 310 and the first heat dissipation face.

S140: Dispose the second heat sink 330 on the second heat dissipation face.

S150: Place the first material 210 between the second heat sink 330 and the second heat dissipation face.

S160: Heat the first material 210.

S170: Cool the first material 210 on the first heat dissipation face to connect the power semiconductor component and the first heat sink 310. Cool the first material 210 on the second heat dissipation face to connect the power semiconductor component and the second heat sink 330.

In the foregoing method for producing a power semiconductor module used to produce the single-faced heat dissipation power semiconductor module, the first material 210 may be heated by using different processes in the step S160.

Optionally, in the step S160, the first material 210 is heated through ultrasonic brazing. A method for heating the first material 210 through ultrasonic brazing includes:
S161a: Align the first material 210 by using an ultrasonic tool head.
S161b: Emit an ultrasonic wave to the first material 210 by using the ultrasonic tool head.

In the step S161a, a material of the ultrasonic tool head may be an aluminum alloy, a titanium alloy, or an alloy steel. All the aluminum alloy, the titanium alloy, and the alloy steel can apply an ultrasonic wave of sufficient amplitude to the power semiconductor or the first heat sink 310, so that a temperature of a soldered end face of the first material 210 reaches 220°C.

In the step S161a, the ultrasonic tool head may be a letter head, a two-claw tool head, or a four-claw tool head. For installation cases of different first materials 210 or different IGBTs, a plurality of tool heads may be used to simultaneously emit ultrasonic waves to the power semiconductor or the first heat sink 310.

In the step S161a, the ultrasonic tool head may generate an ultrasonic wave on the first heat dissipation face, a face that is of the first heat sink 310 and that is away from the power semiconductor component, a face that is of the first heat sink 310 and that faces the power semiconductor component, or a side face of the first heat sink 310. The ultrasonic wave can be kept away from the parts in the power semiconductor component, so that an internal temperature of the power semiconductor component is relatively low, to protect the power semiconductor.

When the first material 210 is heated through ultrasonic brazing, before the step S130, the method may further include the following steps:
S130a: Ultrasonically pre-coat the first material 210 on the first heat dissipation face.
S130b: Ultrasonically pre-coat the first material 210 on the face that is of the first heat sink 310 and that faces the power semiconductor component.

The first material 210 is ultrasonically pre-coated on the first heat dissipation face and/or the first heat sink 310, so that strength of a connection between the power semiconductor component and the first heat sink 310 can be improved, and heat transfer efficiency between the power semiconductor component and the first heat sink 310 can also be improved.

In the step S160, when the first material 210 is heated through ultrasonic brazing, a seventh material combination may be used. In the seventh material combination, the first material 210 may be a multi-element alloy solder paste or SAC305, the second material 230 may be SnSb5, the fourth material 270 may be SAC305, and the fifth material 290 may be SAC305.

In the step S160, the seventh material combination is used. When the seventh material is heated through ultrasonic brazing, a temperature is controlled between 150°C and 180°C. In this case, the ultrasonic brazing concentrates heat at the first material 210, so that the first material 210 formed by the multi-element alloy solder paste or SAC305 is heated and melted. The second material 230 formed by SnSb5 and the fourth material 270 and the fifth material 290 that are formed by SAC305 remain in a solid state, to maintain stability of the power semiconductor component. A melting point of SnSb5 is higher than those of the multi-element alloy solder paste and SAC305. When a temperature is controlled between 150°C and 180°C, SnSb5 in the power semiconductor component is not melted. The ultrasonic brazing concentrates the heat at the first material 210, and temperatures of the fourth material 270 and the fifth material 290 of the power semiconductor component are lower than a temperature of the first material 210, so that when the temperature of the first material 210 is controlled between 150°C and 180°C, a temperature of the fourth material 270 that connects the power device 110 and the conductive pad 120 and a temperature of the fifth material 290 that connects the conductive pad 120 and the second substrate 140 have not reached the melting point of SAC305, and the fourth material 270 and the fifth material 290 are not melted.

In the step S160, when the first material 210 is heated through ultrasonic brazing, an eighth material combination may also be used. In the eighth material combination, the first material 210 may be any one of SnSb5, a multi-element alloy solder paste, and SAC305, the second material 230 may be PbSnAg, the fourth material 270 may be SnSb5, and the fifth material 290 may be SnSb5. In PbSnAg, a weight percentage of lead is 92.5%, a weight percentage of tin is 5.0%, and a weight percentage of silver is 2.5%.

In the step S160, the eighth material combination is used. When the first material 210 is heated through ultrasonic brazing, a temperature is controlled between 210°C and 220°C. In this case, the ultrasonic brazing concentrates heat at the first material 210, so that the first material 210 formed by SnSb5, the multi-element alloy solder paste, or SAC305 is heated and melted. The second material 230 formed by PbSnAg and the fourth material 270 and the fifth material 290 that are formed by SnSb5 remain in a solid state, to maintain stability of the power semiconductor component. A melting point of PbSnAg is higher than that of any one of SnSb5, the multi-element alloy solder paste, and SAC305. When the temperature is controlled between 210°C and 220°C, PbSnAg in the power semiconductor component is not melted. The ultrasonic brazing concentrates the heat at the first material 210, and temperatures of the fourth material 270 and the fifth material 290 of the power semiconductor component are lower than a temperature of the first material 210, so that when the temperature of the first material 210 is controlled between 210°C and 220°C, a temperature of the fourth material 270 that connects the power device 110 and the conductive pad 120 and a temperature of the fifth material 290 that connects the conductive pad 120 and the second substrate 140 have not reached the melting point of SnSb5, and the fourth material 270 and the fifth material 290 are not melted.

Optionally, in the step S160, the first material 210 is heated through vacuum reflow soldering. The vacuum reflow soldering can also concentrate heat in an area in which the first material 210 is located, so that a temperature gradient is formed between the power semiconductor and the heat sink, and an internal temperature of the power semiconductor is reduced when the first material 210 is melted. Vacuum may reduce a bubble inside the first material 210 after the first material 210 is melted, so that after the first material 210 is cooled, strength of a connection between the power semiconductor component and the first heat sink 310 that are connected through soldering is higher.

In the step S160, when the first material 210 is heated through vacuum reflow soldering, a ninth material combination may be used. In the ninth material combination, the first material 210 may be a multi-element alloy solder paste or SAC305, the second material 230 may be PbSnAg, the fourth material 270 may be SnSb5, and the fifth material 290 may be SnSb5.

In the step S160, the ninth material combination is used. When the first material 210 is heated through vacuum reflow soldering, a temperature is controlled between 210°C and 220°C. In this case, the vacuum reflow soldering concentrates heat at the first material 210, so that the first material 210 formed by the multi-element alloy solder paste or SAC305 is heated and melted. The second material 230 formed by PbSnAg and the fourth material 270 and the fifth material 290 that are formed by SnSb5 remain in a solid state, to maintain stability of the power semiconductor component. A melting point of PbSnAg is higher than those of the multi-element alloy solder paste and SAC305. When the temperature is controlled between 210°C and 220°C, PbSnAg in the power semiconductor component is not melted. The vacuum reflow soldering concentrates the heat at the first material 210, and temperatures of the fourth material 270 and the fifth material 290 of the power semiconductor component are lower than a temperature of the first material 210, so that when the temperature of the first material 210 is controlled between 210°C and 220°C, a temperature of the fourth material 270 that connects the power device 110 and the conductive pad 120 and a temperature of the fifth material 290 that connects the conductive pad 120 and the second substrate 140 have not reached the melting point of SnSb5, and the fourth material 270 and the fifth material 290 are not melted.

In the step S160, when the first material 210 is heated through vacuum reflow soldering, a tenth material combination may be used. In the tenth material combination, the first material 210 may be any one of SnSb5, a multi-element alloy solder paste, and SAC305, the second material 230 may be PbSnAg, the fourth material 270 may be PbSnAg, and the fifth material 290 may be PbSnAg.

In the step S160, the tenth material combination is used. When the first material 210 is heated through vacuum reflow soldering, a temperature is controlled between 240°C and 260°C. In this case, the vacuum reflow soldering concentrates heat at the first material 210, so that the first material 210 formed by any one of SnSb5, the multi-element alloy solder paste, and SAC305 is heated and melted. The second material 230, the fourth material 270, and the fifth material 290 that are formed by PbSnAg remain in a solid state, to maintain stability of the power semiconductor component. A melting point of PbSnAg is higher than that of any one of SnSb5, the multi-element alloy solder paste, and SAC305. When the temperature is controlled between 240°C and 260°C, PbSnAg in the power semiconductor component is not melted.

Optionally, in the step S160, the first material 210 is heated through sintering. During sintering, the first material 210 experiences a small external force, and is in a relatively static state. A diffusion region of the first material 210 after being melted is easy to control.

In the step S160, when the first material 210 is heated through sintering, an eleventh material combination may be used. In the eleventh material combination, the first material 210 may be nano silver, the second material 230 may be PbSnAg, the fourth material 270 may be PbSnAg, and the fifth material 290 may be PbSnAg.

In the step S160, the eleventh material combination is used. When the first material 210 is heated through sintering, a temperature is controlled between 270°C and 290°C. In this case, the temperature of the first material 210 is increased through sintering, and the first material 210 formed by the nano silver is heated and softened to form a relatively large intermolecular force. The second material 230, the fourth material 270, and the fifth material 290 that are formed by PbSnAg remain in a solid state, to maintain stability of the power semiconductor component.

It may be understood that when the first material 210 is heated through sintering, the first material 210 may also be micron silver or copper particles. When the first material 210 is heated and softened, the second material 230, the fourth material 270, and the fifth material 290 remain in a solid state.

The power semiconductor module is produced by using the foregoing method for producing a power semiconductor module. The power semiconductor component is first packaged in plastic, and the plastically packaged power semiconductor component forms a separate part to implement separate production. This can improve an automation level and a manufacturing speed. The power semiconductor component that is first packaged in plastic may be detected in advance, thereby ensuring sealing performance after being connected to the heat sink and improving a yield rate. The heat sink is assembled with the plastically packaged power semiconductor component, so that a risk of a stress damage caused by plastic packaging can be reduced, and reliability can be improved. In this manner of forming the power semiconductor component through plastic packaging and then fixedly connecting the heat sink, sealing performance of the power semiconductor module may be improved, so that reliable water cooling may be performed, to ensure a temperature of the power semiconductor module, and improve output performance of the power semiconductor module.

## Claims

1. A method for producing a power semiconductor module, comprising:
packaging (S110) a power device (110) in plastic to form a power semiconductor component, and forming a first heat dissipation face on a surface of the power semiconductor component;
heating (S160) a first material (210) between a first heat sink (310) and the first heat dissipation face; and
cooling (S170) the first material on the first heat dissipation face to connect the power semiconductor component and the first heat sink, wherein before the step of heating the first material between the first heat sink and the first heat dissipation face, the method further comprises:
plating a metal plating layer outside the first heat sink, wherein the metal plating layer comprises any one or more of Ag, Ni, Sn, and Au;
plating a metal plating layer on the surface of the power semiconductor component, wherein the metal plating layer comprises any one or more of Ag, Ni, Sn, and Au.

2. The method for producing a power semiconductor module according to claim 1, wherein the step of packaging (S110) a power device (110) in plastic to form a power semiconductor component comprises:
soldering (S111) a first substrate (130) to a face of the power device by using a second material (230), and forming the first heat dissipation face on a face that is of the first substrate and that is away from the power device, wherein
a melting point of the second material is equal to or higher than a melting point of the first material (210).

3. The method for producing a power semiconductor module according to claim 2, wherein the step of packaging (S110) a power device (110) in plastic to form a power semiconductor component further comprises:
soldering, by using a third material (250), a conductor strip (150) to a face that is of the power device and that is away from the first substrate (130), wherein the power device comprises a first member (111) and a second member (113), and the conductor strip connects the first member and the second member; and
a melting point of the third material is equal to or higher than the melting point of the first material (210).

4. The method for producing a power semiconductor module according to claim 3, wherein the step of heating (S160) a first material (210) between a first heat sink (310) and the first heat dissipation face comprises:
heating the first material through ultrasonic brazing.

5. The method for producing a power semiconductor module according to claim 3, wherein the step of heating (S160) a first material (210) between a first heat sink (310) and the first heat dissipation face comprises:
heating the first material through sintering.

6. The method for producing a power semiconductor module according to claim 2, wherein the step of packaging (S110) a power device (110) in plastic to form a power semiconductor component further comprises:
soldering, by using a fourth material (270), a conductive pad (120) to a face that is of the power device and that is away from the first substrate (130); and
soldering (S113), by using a fifth material (290), a second substrate (140) to a face that is of the conductive pad and that is away from the power device, and forming a second heat dissipation face on a face that is of the second substrate and that is away from the power device, wherein
a melting point of the fourth material is equal to or higher than the melting point of the first material (210), and
a melting point of the fifth material is equal to or higher than the melting point of the first material.

7. The method for producing a power semiconductor module according to claim 6, wherein the step of heating (S160) a first material (210) between a first heat sink (310) and the first heat dissipation face further comprises:
heating a first material (210) between a second heat sink (330) and the second heat dissipation face; and
after the step of heating a first material between a first heat sink and the first heat dissipation face, the method further comprises:
cooling the first material on the second heat dissipation face to connect the power semiconductor component and the second heat sink.

8. The method for producing a power semiconductor module according to claim 7, wherein the step of heating (S160) a first material (210) between a first heat sink (310) and the first heat dissipation face comprises:
heating the first material through ultrasonic brazing.

9. The method for producing a power semiconductor module according to claim 7, wherein the step of heating (S160) a first material (210) between a first heat sink (310) and the first heat dissipation face comprises:
heating the first material through sintering.

10. The method for producing a power semiconductor module according to claim 1, wherein before the step of heating (S160) a first material (210) between a first heat sink (310) and the first heat dissipation face, the method further comprises: disposing, on the first heat dissipation face, an elevation member configured to identify a usage amount of the first material, wherein the elevation member comprises one of the following:
a metal material that is disposed on the first heat dissipation face, wherein the metal material protrudes from the first heat dissipation face to form the elevation member;
a bump that is fastened on the first heat dissipation face, wherein the bump forms the elevation member; and
a groove that is disposed on the first heat dissipation face, wherein the groove forms the elevation member.

11. The method for producing a power semiconductor module according to claim 2 or 6, wherein after the step of packaging a power device (110) in plastic to form a power semiconductor component, the method further comprises:
trimming a power semiconductor.

12. The method for producing a power semiconductor module according to claim 2, wherein after the step of soldering a first substrate (130) to a face of the power device (110) by using a second material (230), the method further comprises:
forming (S101) a first arc-shaped segment in a middle part of the first substrate, wherein the arc-shaped segment is formed by either bending the first substrate to form the first arc-shaped segment or performing heat treatment when the first substrate is formed.

## Patentansprüche

1. Verfahren zur Herstellung eines Leistungshalbleitermoduls, umfassend:
Verpacken (S110) einer Leistungsvorrichtung (110) in Kunststoff, um eine Leistungshalbleiterkomponente zu bilden, und Bilden einer ersten Wärmeableitungsfläche auf einer Oberfläche der Leistungshalbleiterkomponente;
Erhitzen (S160) eines ersten Materials (210) zwischen einem ersten Kühlkörper (310) und der ersten Wärmeableitungsfläche; und
Abkühlen (S170) des ersten Materials auf der ersten Wärmeableitungsfläche, um die Leistungshalbleiterkomponente und den ersten Kühlkörper zu verbinden, wobei das Verfahren vor dem Schritt des Erwärmens des ersten Materials zwischen dem ersten Kühlkörper und der ersten Wärmeableitungsfläche ferner Folgendes umfasst:
Plattieren einer Metallplattierungsschicht außerhalb des ersten Kühlkörpers, wobei die Metallplattierungsschicht eines oder mehrere der Elemente Ag, Ni, Sn und Au umfasst;
Plattieren einer Metallplattierungsschicht auf der Oberfläche der Leistungshalbleiterkomponente, wobei die Metallplattierungsschicht eines oder mehrere der Elemente Ag, Ni, Sn und Au umfasst.

2. Verfahren zur Herstellung eines Leistungshalbleitermoduls nach Anspruch 1, wobei der Schritt des Verpackens (S110) einer Leistungsvorrichtung (110) in Kunststoff zum Bilden einer Leistungshalbleiterkomponente Folgendes umfasst:
Löten (S111) eines ersten Substrats (130) an eine Fläche der Leistungsvorrichtung unter Verwendung eines zweiten Materials (230) und Bilden der ersten Wärmeableitungsfläche auf einer Fläche, die aus dem ersten Substrat besteht und die von der Leistungsvorrichtung abgewandt ist, wobei
ein Schmelzpunkt des zweiten Materials gleich oder höher als ein Schmelzpunkt des ersten Materials (210) ist.

3. Verfahren zur Herstellung eines Leistungshalbleitermoduls nach Anspruch 2, wobei der Schritt des Verpackens (S110) einer Leistungsvorrichtung (110) in Kunststoff zum Bilden einer Leistungshalbleiterkomponente ferner Folgendes umfasst:
Löten eines Leiterstreifens (150) unter Verwendung eines dritten Materials (250) an eine Fläche der Leistungsvorrichtung, die von dem ersten Substrat (130) abgewandt ist, wobei die Leistungsvorrichtung ein erstes Element (111) und ein zweites Element (113) umfasst und der Leiterstreifen das erste Element und das zweite Element verbindet; und
ein Schmelzpunkt des dritten Materials gleich oder höher als der Schmelzpunkt des ersten Materials (210) ist.

4. Verfahren zur Herstellung eines Leistungshalbleitermoduls nach Anspruch 3, wobei der Schritt des Erhitzens (S160) eines ersten Materials (210) zwischen einem ersten Kühlkörper (310) und der ersten Wärmeableitungsfläche Folgendes umfasst:
Erhitzen des ersten Materials durch Ultraschalllöten.

5. Verfahren zur Herstellung eines Leistungshalbleitermoduls nach Anspruch 3, wobei der Schritt des Erhitzens (S160) eines ersten Materials (210) zwischen einem ersten Kühlkörper (310) und der ersten Wärmeableitungsfläche Folgendes umfasst:
Erhitzen des ersten Materials durch Sintern.

6. Verfahren zur Herstellung eines Leistungshalbleitermoduls nach Anspruch 2, wobei der Schritt des Verpackens (S110) einer Leistungsvorrichtung (110) in Kunststoff zum Bilden einer Leistungshalbleiterkomponente ferner Folgendes umfasst:
Löten einer leitfähigen Kontaktstelle (120) unter Verwendung eines vierten Materials (270) an eine Fläche der Leistungsvorrichtung, die vom ersten Substrat (130) abgwandt ist; und
Löten (S113) eines zweiten Substrats (140) unter Verwendung eines fünften Materials (290) an eine Fläche der leitfähigen Kontaktstelle, die von der Leistungsvorrichtung abgewandt ist, und Bilden einer zweiten Wärmeableitungsfläche auf einer Fläche des zweiten Substrats, die von der Leistungsvorrichtung abgewandt ist, wobei
ein Schmelzpunkt des vierten Materials gleich oder höher als der Schmelzpunkt des ersten Materials (210) ist, und
ein Schmelzpunkt des fünften Materials gleich oder höher als der Schmelzpunkt des ersten Materials ist.

7. Verfahren zur Herstellung eines Leistungshalbleitermoduls nach Anspruch 6, wobei der Schritt des Erhitzens (S160) eines ersten Materials (210) zwischen einem ersten Kühlkörper (310) und der ersten Wärmeableitungsfläche ferner Folgendes umfasst:
Erhitzen eines ersten Materials (210) zwischen einem zweiten Kühlkörper (330) und der zweiten Wärmeableitungsfläche; und
nach dem Schritt des Erhitzens eines ersten Materials zwischen einem ersten Kühlkörper und der ersten Wärmeableitungsfläche das Verfahren ferner Folgendes umfasst:
Kühlen des ersten Materials auf der zweiten Wärmeableitungsfläche, um die Leistungshalbleiterkomponente und den zweiten Kühlkörper zu verbinden.

8. Verfahren zur Herstellung eines Leistungshalbleitermoduls nach Anspruch 7, wobei der Schritt des Erhitzens (S160) eines ersten Materials (210) zwischen einem ersten Kühlkörper (310) und der ersten Wärmeableitungsfläche Folgendes umfasst:
Erhitzen des ersten Materials durch Ultraschalllöten.

9. Verfahren zur Herstellung eines Leistungshalbleitermoduls nach Anspruch 7, wobei der Schritt des Erhitzens (S160) eines ersten Materials (210) zwischen einem ersten Kühlkörper (310) und der ersten Wärmeableitungsfläche Folgendes umfasst:
Erhitzen des ersten Materials durch Sintern.

10. Verfahren zum Herstellen eines Leistungshalbleitermoduls nach Anspruch 1, wobei vor dem Schritt des Erhitzens (S160) eines ersten Materials (210) zwischen einem ersten Kühlkörper (310) und der ersten Wärmeableitungsfläche das Verfahren ferner Folgendes umfasst: Anordnen eines Anhebeelements auf der ersten Wärmeableitungsfläche, das dazu konfiguriert ist, eine Nutzungsmenge des ersten Materials zu identifizieren, wobei das Anhebeelement eines der Folgenden umfasst:
ein Metallmaterial, das auf der ersten Wärmeableitungsfläche angeordnet ist, wobei das Metallmaterial von der ersten Wärmeableitungsfläche hervorsteht, um das Anhebeelement zu bilden;
einen Höcker, der auf der ersten Wärmeableitungsfläche befestigt ist, wobei der Höcker das Anhebeelement bildet; und
eine Nut, die auf der ersten Wärmeableitungsfläche angeordnet ist, wobei die Nut das Anhebeelement bildet.

11. Verfahren zum Herstellen eines Leistungshalbleitermoduls nach Anspruch 2 oder 6, wobei das Verfahren nach dem Schritt des Verpackens einer Leistungsvorrichtung (110) in Kunststoff zum Bilden einer Leistungshalbleiterkomponente weiterhin Folgendes umfasst:
Trimmen eines Leistungshalbleiters.

12. Verfahren zum Herstellen eines Leistungshalbleitermoduls nach Anspruch 2, wobei das Verfahren nach dem Schritt des Lötens eines ersten Substrats (130) an eine Fläche der Leistungsvorrichtung (110) unter Verwendung eines zweiten Materials (230) weiterhin Folgendes umfasst:
Bilden (S101) eines ersten bogenförmigen Segments in einem Mittelteil des ersten Substrats, wobei das bogenförmige Segment entweder durch Biegen des ersten Substrats zum Bilden des ersten bogenförmigen Segments oder durch Durchführen einer Wärmebehandlung beim Bilden des ersten Substrats gebildet wird.

## Revendications

1. Procédé de production d'un module semi-conducteur de puissance, comprenant :
le conditionnement (S110) d'un dispositif de puissance (110) dans du plastique pour former un composant semi-conducteur de puissance, et la formation d'une première face de dissipation thermique sur une surface du composant semi-conducteur de puissance ;
le chauffage (S160) d'un premier matériau (210) entre un premier dissipateur thermique (310) et la première face de dissipation thermique ; et
le refroidissement (S170) du premier matériau sur la première face de dissipation thermique pour connecter le composant semi-conducteur de puissance et le premier dissipateur thermique, dans lequel avant l'étape de chauffage du premier matériau entre le premier dissipateur thermique et la première face de dissipation thermique, le procédé comprenant en outre :
le placage d'une couche de placage métallique à l'extérieur du premier dissipateur thermique, dans lequel la couche de placage métallique comprend un ou plusieurs parmi Ag, Ni, Sn et Au ;
le placage d'une couche de placage métallique sur la surface du composant semi-conducteur de puissance, dans lequel la couche de placage métallique comprend un ou plusieurs parmi Ag, Ni, Sn et Au.

2. Procédé de production d'un module semi-conducteur de puissance selon la revendication 1, dans lequel l'étape de conditionnement (S110) d'un dispositif de puissance (110) dans du plastique pour former un composant semi-conducteur de puissance comprend :
le soudage (S111) d'un premier substrat (130) sur une face du dispositif de puissance à l'aide d'un deuxième matériau (230), et la formation de la première face de dissipation thermique sur une face qui appartient au premier substrat et qui est éloignée du dispositif de puissance, dans lequel
un point de fusion du deuxième matériau est supérieur ou égal à un point de fusion du premier matériau (210).

3. Procédé de production d'un module semi-conducteur de puissance selon la revendication 2, dans lequel l'étape de conditionnement (S110) d'un dispositif de puissance (110) dans du plastique pour former un composant semi-conducteur de puissance comprend en outre :
le soudage, à l'aide d'un troisième matériau (250), d'une bande conductrice (150) sur une face qui appartient au dispositif de puissance et qui est éloignée du premier substrat (130), dans lequel le dispositif de puissance comprend un premier élément (111) et un second élément (113), et la bande conductrice connecte le premier élément et le second élément ; et
un point de fusion du troisième matériau est supérieur ou égal au point de fusion du premier matériau (210).

4. Procédé de production d'un module semi-conducteur de puissance selon la revendication 3, dans lequel l'étape de chauffage (S160) d'un premier matériau (210) entre un premier dissipateur thermique (310) et la première face de dissipation thermique comprend :
le chauffage du premier matériau par brasage par ultrasons.

5. Procédé de production d'un module semi-conducteur de puissance selon la revendication 3, dans lequel l'étape de chauffage (S160) d'un premier matériau (210) entre un premier dissipateur thermique (310) et la première face de dissipation thermique comprend :
le chauffage du premier matériau par frittage.

6. Procédé de production d'un module semi-conducteur de puissance selon la revendication 2, dans lequel l'étape de conditionnement (S110) d'un dispositif de puissance (110) dans du plastique pour former un composant semi-conducteur de puissance comprend en outre :
le soudage, à l'aide d'un quatrième matériau (270), d'une plage conductrice (120) sur une face qui appartient au dispositif de puissance et qui est éloignée du premier substrat (130) ; et
le soudage (S113), à l'aide d'un cinquième matériau (290), d'un second substrat (140) sur une face qui appartient à la plage conductrice et qui est éloignée du dispositif de puissance, et
la formation d'une seconde face de dissipation thermique sur une face qui appartient au second substrat et qui est éloignée du dispositif de puissance, dans lequel
un point de fusion du quatrième matériau est supérieur ou égal au point de fusion du premier matériau (210), et
un point de fusion du cinquième matériau est supérieur ou égal au point de fusion du premier matériau.

7. Procédé de production d'un module semi-conducteur de puissance selon la revendication 6, dans lequel l'étape de chauffage (S160) d'un premier matériau (210) entre un premier dissipateur thermique (310) et la première face de dissipation thermique comprend en outre :
le chauffage d'un premier matériau (210) entre un second dissipateur thermique (330) et la seconde face de dissipation thermique ; et
après l'étape de chauffage d'un premier matériau entre un premier dissipateur thermique et la première face de dissipation thermique, le procédé comprend en outre :
le refroidissement du premier matériau sur la seconde face de dissipation thermique pour connecter le composant semi-conducteur de puissance et le second dissipateur thermique.

8. Procédé de production d'un module semi-conducteur de puissance selon la revendication 7, dans lequel l'étape de chauffage (S160) d'un premier matériau (210) entre un premier dissipateur thermique (310) et la première face de dissipation thermique comprend :
le chauffage du premier matériau par brasage par ultrasons.

9. Procédé de production d'un module semi-conducteur de puissance selon la revendication 7, dans lequel l'étape de chauffage (S160) d'un premier matériau (210) entre un premier dissipateur thermique (310) et la première face de dissipation thermique comprend :
le chauffage du premier matériau par frittage.

10. Procédé de production d'un module semi-conducteur de puissance selon la revendication 1, dans lequel avant l'étape de chauffage (S160) d'un premier matériau (210) entre un premier dissipateur thermique (310) et la première face de dissipation thermique, le procédé comprend en outre : la disposition, sur la première face de dissipation de chaleur, d'un élément d'élévation configuré pour identifier une quantité utilisée du premier matériau, dans lequel l'élément d'élévation comprend l'un parmi :
un matériau métallique qui est disposé sur la première face de dissipation thermique, dans lequel le matériau métallique dépasse de la première face de dissipation thermique pour former l'élément d'élévation ;
une bosse qui est fixée sur la première face de dissipation de chaleur, dans lequel la bosse forme l'élément d'élévation ; et
une rainure qui est disposée sur la première face de dissipation de chaleur, dans lequel la rainure forme l'élément d'élévation.

11. Procédé de production d'un module semi-conducteur de puissance selon la revendication 2 ou 6, dans lequel l'étape de conditionnement d'un dispositif de puissance (110) dans du plastique pour former un composant semi-conducteur de puissance, le procédé comprend en outre :
le découpage d'un semi-conducteur de puissance.

12. Procédé de production d'un module semi-conducteur de puissance selon la revendication 2, dans lequel après l'étape de soudage d'un premier substrat (130) sur une face du dispositif de puissance (110) à l'aide d'un deuxième matériau (230), le procédé comprend en outre :
la formation (S101) d'un premier segment en forme d'arc dans une partie médiane du premier substrat, dans lequel le segment en forme d'arc est formé soit en pliant le premier substrat pour former le premier segment en forme d'arc, soit en effectuant un traitement thermique lorsque le premier substrat est formé.
